(19) Europäisches Patentamt

European Patent Office

Office européen des brevets

(11) **EP 4 742 052 A1**

(12) # EUROPEAN PATENT APPLICATION

(43) Date of publication:
**13.05.2026 Bulletin 2026/20**

(21) Application number: **25214981.0**

(22) Date of filing: **11.11.2025**

(51) International Patent Classification (IPC):
**G06F 15/78** (2006.01)

(52) Cooperative Patent Classification (CPC):
**G06F 15/7821**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **12.11.2024 KR 20240160451**

(71) Applicant: **Samsung Electronics Co., Ltd.
Suwon-si, Gyeonggi-do 16677 (KR)**

(72) Inventors:
• **Lee, Sunjung
16678 Suwon-si, Gyeonggi-do (KR)**

• **Yu, Jaehoon
16678 Suwon-si, Gyeonggi-do (KR)**
• **Lee, Suk Han
16678 Suwon-si, Gyeonggi-do (KR)**
• **Cha, Sanghoon
16678 Suwon-si, Gyeonggi-do (KR)**
• **Han, Wontak
16678 Suwon-si, Gyeonggi-do (KR)**

(74) Representative: **Grünecker Patent- und Rechtsanwälte
PartG mbB
Leopoldstraße 4
80802 München (DE)**

(54) **MEMORY DEVICE AND OPERATING METHOD WITH DATA FORMAT OPERATION**

(57)    A memory device includes a processing-in-memory (PIM) block configured to perform an operation between a weight value, which is represented by a weight scale factor and a weight element, and an input value, which is represented by an input scale factor and an input element, wherein the PIM block includes a first scale register file storing the input scale factor, a second scale register file storing the weight scale factor, a scalar register file (SRF) storing the input element, a plurality of arithmetic logic units (ALUs) configured to, in response to an operation command received from a host, perform, in parallel, a first operation between the input scale factor and the weight scale factor and a second operation between the input element and the weight element, and an accumulator configured to accumulate and store an operation result from the first operation and the second operation.

<u>**100**</u>

**FIG. 1**

**EP 4 742 052 A1**

# EP 4 742 052 A1

**Description**

BACKGROUND

1. Field

The following description relates to a memory device and operating method with a data format operation.

2. Description of Related Art

Efficient and high-performance neural network processing is important for devices such as computers, smartphones, tablets, and wearables. The processing performance increased by the decreasing power consumption of the devices has enabled the implementation of a hardware accelerator specific to performing a specialized task. For example, a plurality of hardware accelerators may be connected to generate a computation graph for applications such as natural language processing (NLP), language translation, and text generation. Therefore, a subsystem for accelerating NLP, language translation, and text generation may include a plurality of specialized hardware accelerators having efficient streaming interconnections for data transmission between the hardware accelerators. A near-memory accelerator may be a hardware accelerator implemented near a memory. In-memory computing (IMC) may be an implementation of a hardware accelerator inside a memory.

SUMMARY

The invention is claimed in the independent claims. Preferred embodiments are specified in the dependent claims.

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

In one or more general aspects, a memory device includes a processing-in-memory (PIM) block configured to perform an operation between a weight value, which is represented by a weight scale factor and a weight element, and an input value, which is represented by an input scale factor and an input element, wherein the PIM block may include a first scale register file storing the input scale factor, a second scale register file storing the weight scale factor, a scalar register file (SRF) storing the input element, a plurality of arithmetic logic units (ALUs) configured to, in response to an operation command received from a host, perform, in parallel, a first operation between the input scale factor and the weight scale factor and a second operation between the input element and the weight element, and an accumulator configured to accumulate and store an operation result from the first operation and the second operation.

The memory device may include a control circuit configured to, for the performing of the first operation and the second operation in parallel, in response to the operation command, provide, in parallel, a first operation signal instructing a first ALU among the plurality of ALUs according to the first operation and provide a second operation signal instructing a second ALU among the plurality of ALUs according to the second operation.

For the accumulating and storing of the operation result, the control circuit may be configured to provide the accumulator with a third operation signal indicating a conversion into the operation result represented in a specific data format from a first partial result of the first operation and a second partial result of the second operation, at a timing after a first specific cycle has elapsed from the first operation signal and the second operation signal.

For the accumulating and storing of the operation result, the control circuit may be configured to provide the accumulator with a fourth operation signal indicating an addition of the operation result to a pre-stored value of the accumulator, at a timing after a second specific cycle has elapsed from the third operation signal.

The memory device may include an accumulation register file (ARF), wherein the accumulator may include a data type converter configured to generate the operation result by merging a first partial result of the first operation and a second partial result of the second operation into a specific data format, and an adder configured to add the generated operation result to a pre-stored value in the ARF.

The input scale factor may include an exponent component of the input value, the input element may include a mantissa component of the input value, the weight scale factor may include an exponent component of the weight value, and the weight element may include a mantissa component of the weight value.

The plurality of ALUs may include a first ALU configured to perform, as the first operation, an addition of the exponent component of the input value and the exponent component of the weight value, and a second ALU configured to perform, as the second operation, a multiplication of the mantissa component of the input value and the mantissa component of the weight value.

The memory device may be configured to, in response to receiving, from the host, a plurality of operation commands comprising the operation command, perform a dot product operation between an input vector comprising a plurality of input values and a weight matrix comprising a plurality of weight values.

The memory device may include a memory bank storing the weight scale factor and the weight element, wherein the input scale factor and the input element are received from the host, in response to a command preceding the operation command, and the weight scale factor is loaded from the memory bank, in response to a command preceding the operation command.

The memory device may be configured to receive, from the host, and process a first plurality of operation commands for data sharing a first scale factor and a second plurality of operation commands for data sharing a second scale factor, without a fence.

In one or more general aspects, an operating method of a memory device includes receiving an operation command from a host, in response to the received operation command, performing, by a plurality of arithmetic logic units (ALUs), a first operation between an input scale factor of an input value and a weight scale factor of a weight value and a second operation between an input element of the input value and a weight element of the weight value, in parallel, and accumulating an operation result from the first operation and the second operation and storing the accumulated operation result.

The performing of the first operation and the second operation in parallel by the plurality of ALUs may include in response to the operation command, providing a first ALU among the plurality of ALUs with a first operation signal indicating the first operation, and providing a second ALU among the plurality of ALUs with a second operation signal indicating the second operation, wherein the providing of the first operation signal and the providing of the second operation signal are performed in parallel by a control circuit.

The storing of the accumulated operation result may include providing an accumulator with a third operation signal indicating a conversion into the operation result represented in a specific data format from a first partial result of the first operation and a second partial result of the second operation, at a timing after a first specific cycle has elapsed from the first operation signal and the second operation signal.

The storing of the accumulated operation result may include providing the accumulator with a fourth operation signal indicating an addition of the operation result and a pre-stored value of the accumulator, at a timing after a second specific cycle has elapsed from the third operation signal.

The storing of the accumulated computation result may include generating the operation result by merging a first partial result of the first operation and a second partial result of the second operation into a specific data format, and adding the generated operation result to a pre-stored value in an accumulation register file (ARF).

The input scale factor may include an exponent component of the input value, the input element may include a mantissa component of the input value, the weight scale factor may include an exponent component of the weight value, and the weight element may include a mantissa component of the weight value.

The performing of the first operation and the second operation in parallel by the plurality of ALUs may include performing, by a first ALU, an addition of the exponent component of the input value and the exponent component of the weight value as the first operation, and performing, by a second ALU, a multiplication of the mantissa component of the input value and the mantissa component of the weight value as the second operation.

The operating method may include in response to receiving, from the host, a plurality of operation commands comprising the operation command, performing a dot product operation between an input vector comprising a plurality of input values and a weight matrix comprising a plurality of weight values.

The receiving of the operation command may include, in response to a command preceding the operation command, receiving the input scale factor from the host and storing the received input scale factor in a first scale register file, and, in response to a command preceding the operation command, receiving the input element from the host and storing the received input element in a scalar register file (SRF), and, in response to a command preceding the operation command, loading the weight scale factor from a memory bank and storing the loaded weight scale factor in a second scale register file.

In one or more general aspects, a processing-in-memory (PIM) device includes a plurality of arithmetic logic units (ALUs) configured to, for each of a plurality of input elements sharing a same input scale factor and each of a plurality of weight elements sharing a same weight scale factor, perform a first operation between the same input scale factor received from a first scale register file and the same weight scale factor received from a second scale register file, and a second operation between the respective input element received from a scalar register file (SRF) and the respective weight element.

Other features and aspects will be apparent from the following detailed description, the drawings, and the claims.

BRIEF DESCRIPTION OF THE DRAWINGS

FIG. 1 illustrates an example of a computing system according to one or more example embodiments.

FIGS. 2A and 2B illustrate examples of a memory device according to one or more example embodiments.

FIG. 3 illustrates an example of an operating method of a memory device according to one or more example embodiments.

FIG. 4 illustrates an example of a data format sharing a scale factor according to one or more example embodiments.

FIG. 5 illustrates an example of an operation on data represented in a data format according to one or more example embodiments.

FIG. 6 illustrates an example configuration of a processing-in-memory (PIM) block supporting an operation on data represented in a data format according to one or more example embodiments.

FIG. 7 illustrates an example of a multiply-accumulate (MAC) operation performed in a computing system according to one or more example embodiments.

FIG. 8 illustrates an example of a reduced fence in a computing device according to one or more example embodiments.

FIG. 9 illustrates an example of a fence used according to a comparative example embodiment.

FIG. 10 illustrates an improved performance of a memory device according to one or more example embodiments over a comparative example embodiment.

Throughout the drawings and the detailed description, unless otherwise described or provided, the same drawing reference numerals may be understood to refer to the same or like elements, features, and structures. The drawings may not be to scale, and the relative size, proportions, and depiction of elements in the drawings may be exaggerated for clarity, illustration, and convenience.

DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, descriptions of features that are known after an understanding of the disclosure of this application may be omitted for increased clarity and conciseness.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

The terminology used herein is for describing various examples only and is not to be used to limit the disclosure. The articles "a," "an," and "the" are intended to include the plural forms as well, unless the context clearly indicates otherwise. As used herein, the term "and/or" includes any one and any combination of any two or more of the associated listed items. As non-limiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof. Additionally, while one embodiment may set forth such terms "comprise" or "comprises," "include" or "includes," and "have" or "has" to specify the presence of stated features, numbers, operations, members, elements, and/or combinations thereof, other embodiments may exist where one or more of the stated features, numbers, operations, members, elements, and/or combinations thereof are not present.

Throughout the specification, when a component or element is described as "connected to," "coupled to," or "joined to" another component, element, or layer, it may be directly "connected to," "coupled to," or "joined to" the other component, element, or layer, or there may reasonably be one or more other components, elements, or layers intervening therebetween. When a component or element is described as "directly connected to," "directly coupled to," or "directly joined to" another component, element, or layer, there can be no other components, elements, or layers intervening therebetween. Likewise, expressions, for example, "between" and "immediately between" and "adjacent to" and "immediately adjacent to" may also be construed as described in the foregoing.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but is used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

As used herein, the term "and/or" includes any one and any combination of any two or more of the associated listed items. The phrases "at least one of A, B, and C", "at least one of A, B, or C", and the like are intended to have disjunctive meanings, and these phrases "at least one of A, B, and C", "at least one of A, B, or C", and the like also include examples where there may be one or more of each of A, B, and/or C (e.g., any combination of one or more of each of A, B, and C), unless the corresponding description and embodiment necessitates such listings (e.g., "at least one of A, B, and C") to be interpreted to have a conjunctive meaning.

Unless otherwise defined, all terms, including technical and scientific terms, used herein have the same meaning as commonly understood by one of ordinary skill in the art to which this disclosure pertains and based on an understanding of the disclosure of the present application. Terms, such as those defined in commonly used dictionaries, are to be interpreted as having a meaning that is consistent with their meaning in the context of the relevant art and the disclosure of the present application and are not to be interpreted in an idealized or overly formal sense unless expressly so defined herein. The use of the term "may" herein with respect to an example or embodiment, e.g., as to what an example or embodiment may include or implement, means that at least one example or embodiment exists where such a feature is included or implemented, while all examples are not limited thereto. The use of the terms "example" or "embodiment" herein have a same meaning (e.g., the phrasing "in one example" has a same meaning as "in one embodiment," and "one or more examples" has a same meaning as "in one or more embodiments").

Hereinafter, examples will be described in detail with reference to the accompanying drawings. When describing the examples with reference to the accompanying drawings, like reference numerals refer to like components and a repeated description related thereto is omitted.

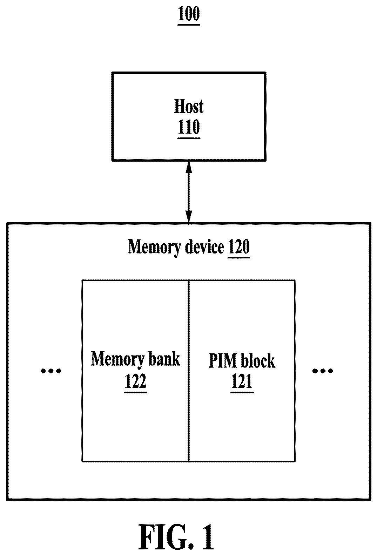

FIG. 1 illustrates an example of a computing system according to one or more example embodiments.

In one or more embodiments, a computing system 100 may include a host 110 and a memory device 120.

The host 110, which is a main management entity of the computing system 100 (e.g., an electronic device), may be implemented as a host processor and/or a server. The host processor may include, for example, a host central processing unit (CPU). The host processor may include, for example, a processor core and a memory controller. The memory controller may control the memory device 120. The host processor may process, via the processor core, data received from the memory device 120 via the memory controller. The memory controller may also transmit commands or instructions to the memory device 120. The commands to be transmitted to the memory device 120 may include, for example, a write command, a read command, and an operation command, which are described as main examples of the commands.

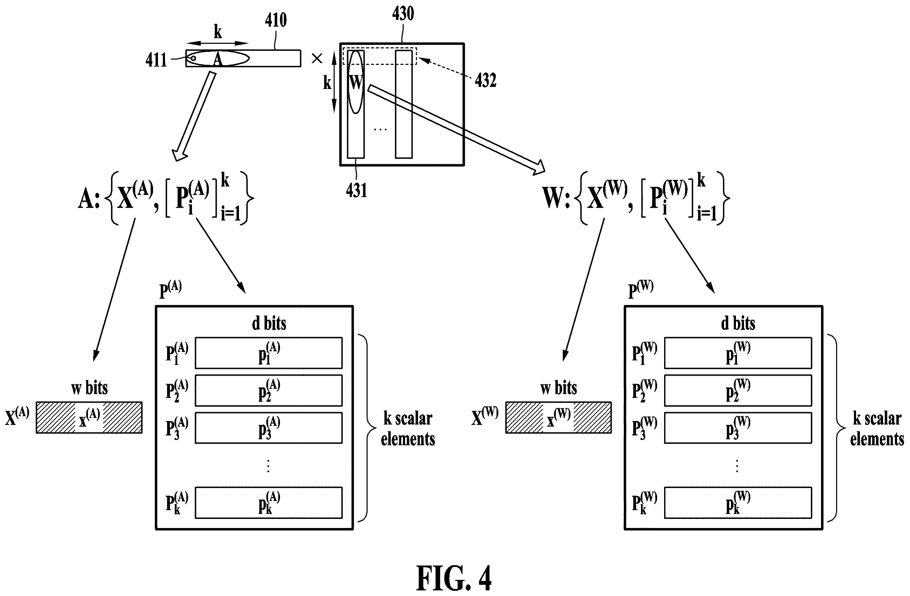

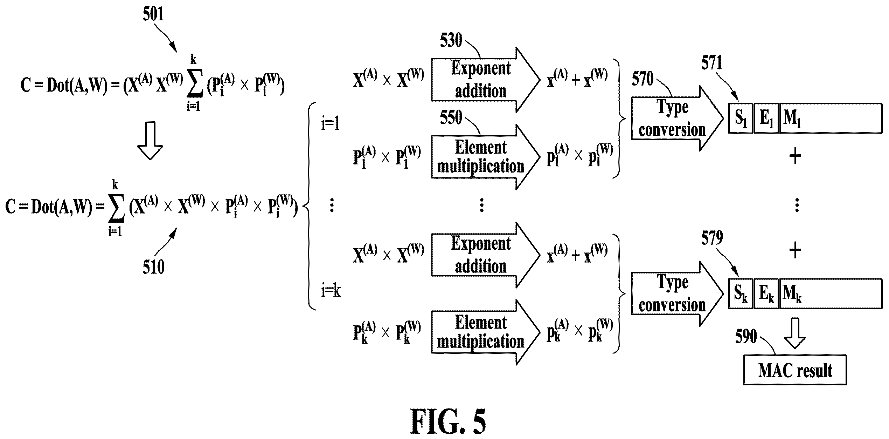

For example, the write command may be a command that instructs writing an input value (or activation value) for a specific operation (e.g., multiply-accumulate (MAC) operation) in a register file of the memory device 120. The read command may be a command that instructs reading a value (e.g., weight value) to be used in a specific operation and loading it from a memory bank 122 of the memory device 120 into a register file. The operation command may be a command that instructs performing a specific operation. The specific operation may be, for example, a dot product operation (or MAC operation) between two vectors. As further described in examples below with reference to FIGS. 4 and 5, a matrix multiplication (or matrix product) between an input vector and a weight matrix (e.g., general matrix-vector multiplication (GEMV) operation) may include a plurality of dot product operations between partial vectors.

For example, the operation command may instruct performing an operation between an input value and a weight fragment of a GEMV operation. As described below, a processing-in-memory (PIM) block 121 of the memory device 120 may perform a MAC operation based on input values and weight values, in response to the operation command. The MAC operation may include respective multiplications of the input values and the weight values and summation (or determining a sum, e.g., an addition operation) of multiplication results from the multiplications. Of note, the operation command may be a dynamic random-access memory (DRAM) command provided to the memory device 120 set in all-bank PIM mode. Of the DRAM command, a DRAM read command (DRAM RD) may correspond to the read command, a DRAM write command (DRAM WR) may correspond to the write command, and a PIMX command may correspond to the operation command. Each operation command may include, as address information, a location where values used in an operation are written in the memory device 120 (e.g., an address indicating a location where a value is written in a memory bank or an index indicating a location where a value is stored in a register file).

The memory device 120 may include a memory region in which data is stored. The memory region may refer to a region (e.g., a physical region) on a memory chip of the memory device 120 from and/or in which data is read and/or written. The memory region may be disposed on a memory die (or core die) of the memory device 120. The memory device 120 may cooperate with the host processor to process data in the memory region. For example, the memory device 120 may perform computation (or operations) or processing on data based on a command or instruction received from the host processor. The memory device 120 may control the memory region in response to the command or instruction from the host processor. The memory device 120 may be separate from the host processor. Of note, the host processor may be responsible for overall computation (or operations) and may delegate an operation that uses acceleration (e.g., PIM) to the memory device 120.

In one or more embodiments, the memory device 120 may include the PIM block 121 and a memory (e.g., a plurality of memory banks). For example, the memory device 120 may perform a target operation using data stored in the memory via a plurality of PIM blocks. The target operation may be, for example, the GEMV operation. Of note, data used in the GEMV operation may be tensor data, e.g., with input data and output data being data in the form of vectors and weight data being data in the form of matrix. The weight data may be stored in the memory device 120 (e.g., a DRAM device) because it has a capacity (e.g., memory size) greater than a cache size of the host 110. Of note, the input vector may be divided into a plurality of partial input vectors, and each partial input vector may include a plurality of scalar values. A partial input vector may also be referred to herein as an "input fragment."

The memory may store data. The plurality of memory banks may be generated using a portion or entirety of the memory chip of the memory device 120. As described herein, each of the plurality of memory banks may store some (e.g., weight fragments which are a portion of the entire weight matrix) of values to be used in the target operation. For example, the target operation may be decomposed into a plurality of partial operations (e.g., specific operations), and each memory bank may store some data to be used in a specific operation. For example, the GEMV operation may be decomposed into a plurality of MAC operations. The memory device 120 and/or the host 110 may divide a weight matrix of a target GEMV operation into weight fragments and store them in the plurality of memory banks. Each memory bank may include a plurality of storage cells that store values in a memory array disposed on the memory die of the memory device 120. The plurality of storage cells may be arranged along row lines and column lines. A portion of a memory bank that includes storage cells arranged along a row line may be referred to as a memory row. The memory row may be a group of storage cells arranged along the same row line. Similarly, a memory column may be a group of storage cells arranged along the same column line.

The PIM block 121 may perform an operation using data stored in the memory according to an operation command. For example, the PIM block 121 may access a memory bank disposed near the PIM block 121 itself among the plurality of memory banks of the memory device 120. The PIM block 121 may acquire data (e.g., a weight fragment) of a portion of the accessible memory bank corresponding to the operation command. The PIM block 121 may perform an operation using the acquired data. For example, the PIM block 121 may perform a portion (e.g., an operation between an input scalar value and weight values of the weight fragment) of the target operation using a weight fragment corresponding to the operation command of a partial weight matrix stored in the bank accessible by the PIM block 121. The PIM block 121 may load the weight fragment and input value corresponding to the operation command and perform multiplication and/or addition operations using the loaded data.

For example, each PIM block 121 may perform a plurality of specific operations included in the target operation (e.g., a GEMV operation). In a case where the target operation is a GEMV operation between an input vector and a weight matrix, the GEMV operation may be decomposed of dot product operations respectively corresponding to a plurality of weight vectors (e.g., column vectors or row vectors) of the weight matrix.

Each dot product operation may be decomposed into partial dot product operations between each of partial vectors (e.g., partial input vectors) of an input vector and corresponding partial vectors (e.g., partial weight vectors) of a weight vector. Each partial dot product operation may include a multiplication operation between an individual value (e.g., input value) of a partial input vector and a corresponding value (e.g., weight value) of a partial weight vector and an addition (or summation) operation that adds (or sums up) a result of the multiplication operation to a result of another multiplication operation.

Here, the input vector may be a dot product for each of a plurality of weight vectors (e.g., column vectors). For example, in a case where there are T weight vectors, T dot product operation results may be generated for the T weight vectors of the input vector. Any value (e.g., input scalar value) of the input vector may be commonly multiplied by values of multiple weight vectors (e.g., column vectors). For example, an ith input value of an input vector may be commonly multiplied by ith weight values (e.g., an ith weight value of a first column vector to an ith weight value of a Tth column vector) of the T column vectors, respectively. In this case, "i" and "T" may each be an integer greater than or equal to 1. A weight fragment may be data that has weight values that are multiplied by the same input scalar value across multiple weight vectors (e.g., partial column vectors).

By a single operation command, the ith weight values may be loaded respectively from T partial weight vectors. One specific operation indicated by one operation command may include, for example, a multiplication between an input value and a weight fragment (e.g., each of the T weight values) and an addition operation that adds a result of the multiplication to a result of another multiplication.

As described below, the **PIM** block 121 may divide a weight value into a weight element and a weight scale factor and an input value into an input element and an input scale factor, and load and process them accordingly. For example, the **PIM** block 121 may load the input scale factor and the weight scale factor from a scale register file (or scaling register file). The weight scale factor may be stored in the scale register file from a memory bank. The PIM block 121 may load the weight element from the memory bank and load the input value from the register file (e.g., a scalar register file (SRF)).

As described above, when T weight elements are loaded by one operation command, a set of the T weight elements may also be referred to as a weight element fragment. The PIM block 121 may perform an operation between the loaded weight fragment and the input value, using a plurality of arithmetic logic units (ALUs). For example, the operation between the weight fragment and the input value may include an operation between the weight scale factor and the input scale factor, and an operation between the weight element fragment and the input element.

Although FIG. 1 shows one memory bank in the core die, near the PIM block 121, but examples are not limited thereto. The PIM block 121 may be disposed near a plurality of memory banks (e.g., two memory banks) to be accessible thereto.

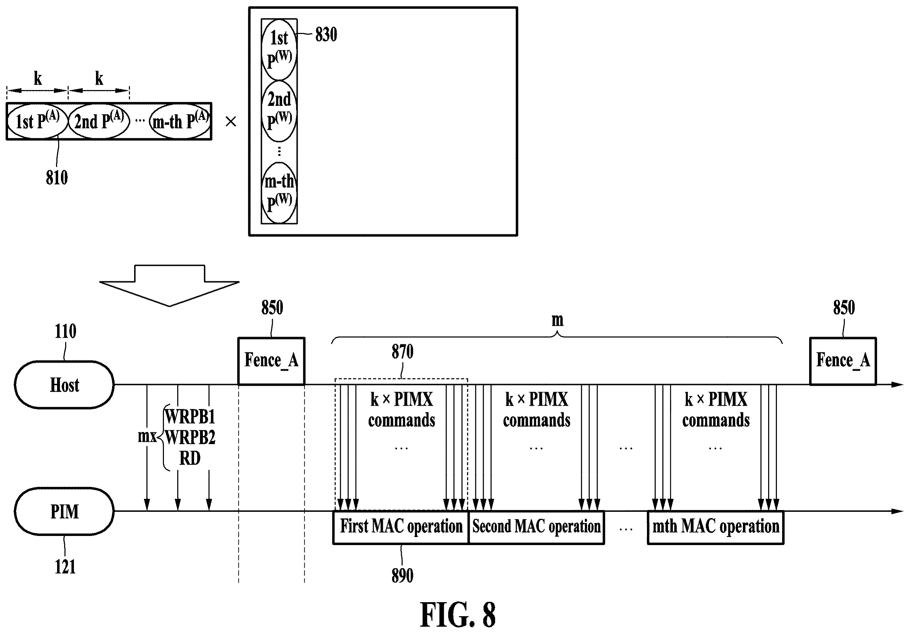

The instructions described herein may include instructions for executing operations of the host processor, the memory device 120, or processors of various devices, and/or instructions for executing operations of the respective components or configurations of processors. For example, the instructions (or programs) executable by the host processor may be stored in another memory device 120, but examples are not limited thereto. The instructions may also include a fence instruction. The fence instruction may be an instruction that executes an operation of disabling the host 110 or resources for a time (e.g., a fence time) corresponding to a fence. For example, a fence instruction for a specific PIM block 121 may be an instruction that executes an operation of deferring, waiting, and/or restricting a transfer of a command (e.g., a write command or an operation command) from the host 110 to the specific PIM block 121. As described below, a fencing operation may be used due to dependency between operations, in a comparative embodiment. An example of the reason why the fencing operation is used is further described below with reference to FIG. 8. The fencing operation may consume a long cycle, and therefore a method and structure of one or more embodiments may reduce the fencing operation for the PIM block 121. For example, the host 110 of one or more embodiments may transmit operation commands for a target operation, without a time corresponding to a fence.

The memory device 120 (e.g., a PIM device) including the PIM block 121 may perform an operation to accelerate application programs (e.g., machine learning and big data) that use a large memory bandwidth. The memory device 120 may perform an operation by accessing, in parallel, a plurality of memory banks via a plurality of PIM blocks 121. The memory device 120 may perform an operation with an internal memory bandwidth that is higher than an external memory bandwidth. Therefore, the memory device 120 of one or more embodiments may significantly reduce an execution time (or "runtime" herein) of a memory-intensive application program. The memory device 120 of one or more embodiments may also move data only between the PIM block 121 and a memory bank, thereby reducing power consumption.

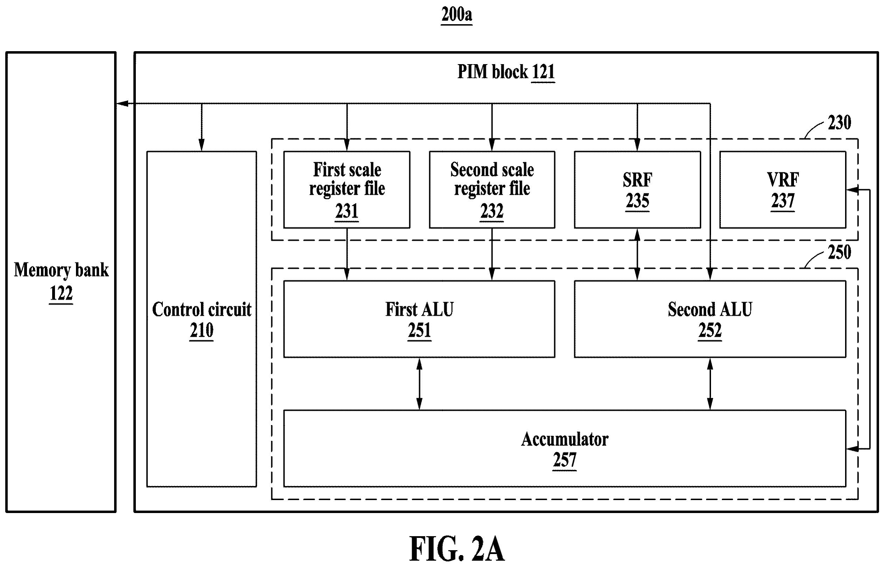

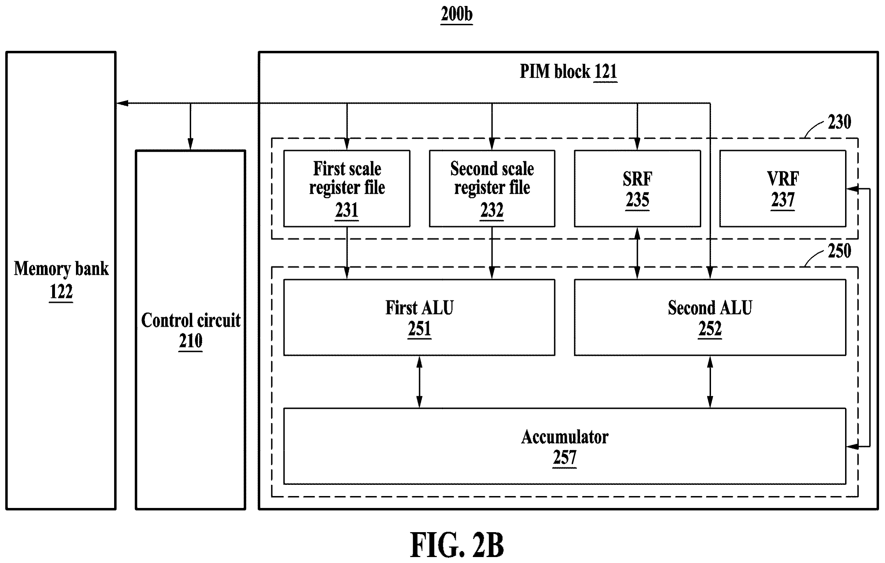

FIGS. 2A and 2B illustrate examples of a memory device according to one or more example embodiments.

In one or more embodiments, a PIM block 121 of a memory device (e.g., either of a memory device 200a of FIG. 2A and a memory device 200b of FIG. 2B) (e.g., the memory device 120 of FIG. 1) may perform an operation between a weight value and an input value. As described in an example below with reference to FIG. 4, a plurality of data (e.g., k numerical values, where "k" is an integer greater than or equal to 2) may share the same scale factor, and each of the plurality of data may include a corresponding element (or private element). For example, the weight value may be represented by a weight scale factor and a weight element. The input value may be represented by an input scale factor and an input element.

For example, the PIM block 121 may include register files 230 and ALUs 250. Referring to the memory device 200a shown in FIG. 2A, the PIM block 121 may include a control circuit 210 in addition to the components described above. However, examples are not limited thereto, and referring to the memory device 200b shown in FIG. 2B, the control circuit 210 may be disposed outside the PIM block 121 and connected to other components.

As described above, the PIM block 121 may be disposed near a corresponding memory bank 122 among a plurality of memory banks of the memory device (e.g., 200a and 200b). The PIM block 121 may access the nearby memory bank 122 via a bank interface. The memory bank 122 may store weight values as described above. As described below, each weight value may be data in a data format represented by a weight scale factor and a weight element. The memory bank 122 may store, as the weight value, the weight scale factor and the weight element.

The control circuit 210 may receive an operation command. The operation command may refer to a command that instructs performing a specific operation (e.g., a portion of MAC operations or dot product operations) and may include information (e.g., address information or index information) that indicates a location where a value (e.g., weight) is stored in the memory device (e.g., 200a and 200b), as described above. The address information may include an address that indicates a location in the memory bank 122 where the weight element is stored. The index information may include an index that indicates a location in a scale register file where the weight scale factor is stored.

In response to the received operation command, the control circuit 210 may control the plurality of ALUs 250 to perform, in parallel, a first operation between the input scale factor and the weight scale factor and a second operation between the input element and the weight element. For example, in response to the operation command, the control circuit 210 may provide a first operation signal that instructs a first ALU among the plurality of ALUs 250 according to the first operation and may also provide a second operation signal that instructs a second ALU among the plurality of ALUs 250 according to the second operation. In this example, the control circuit 210 may provide the first operation signal and provide the second operation signal, in parallel.

The control circuit 210 may load values (e.g., the input scale factor, the input element, the weight scale factor, and the weight element) indicated by the received operation command from corresponding register files.

Based on the received operation command, the control circuit 210 may also identify, in the PIM block 121, scale register files (e.g., a first scale register file 231 and a second scale register file 232) that store the scale factors, identify a scalar register file (e.g., a scalar register file (SRF) 235) that stores the input element, and identify a register file (e.g., a vector register file (VRF) 237) that stores a result of a specific operation (e.g., a MAC operation). For example, the control circuit 210 may determine, based on location information (e.g., memory address) indicated by the operation command, a location in a register file at which a value to be used for a corresponding operation is stored or information (e.g., an index) indicating a location at which a result of the operation is to be stored.

The register files 230 may be devices that include logic circuits (e.g., digital logic circuits) implementing storage functionality. The register files 230 may include the scale register files, the SRF 235, and the VRF 237.

The scale register files may store corresponding scale factors. For example, the first scale register file 231 may store the input scale factor, and the second scale register file 232 may store the weight scale factor.

The SRF 235 may store scalar values. For example, the SRF 235 may store the input element. Of note, although one SRF (e.g., the SRF 235) is shown in FIGS. 2A and 2B, examples are not limited thereto, and the PIM block 121 may include a plurality of SRFs where each SRF may store a plurality of input scalar values. For example, an input vector used in a GEMV operation may include a plurality of partial input vectors, and each partial input vector may include a plurality of input fragments (e.g., input scalar values).

The VRF 237 may store vector values. The VRF 237 may be used as an accumulation register file (ARF). The VRF 237 may store an accumulated result (e.g., a vector sum of resulting vectors including multiplication results) of operation results according to a plurality of operation commands. For example, the ARF may store an accumulated operation result from the first operation between the scale factors (e.g., the input scale factor and the weight scale factor) and the second operation between the elements (e.g., the input element and the weight element). However, examples are not limited thereto, and the PIM block 121 may also include an ARF separate from the VRF 237 where the PIM block 121 may accumulate operation results in the ARF during operations and may move a result of the accumulating of the operation results to the VRF 237 when the operations are completed.

Of note, although one VRF (e.g., the VRF 237) is shown in FIGS. 2A and 2B, examples are not limited thereto, and the PIM block 121 may include a plurality of VRFs where each VRF may store a result of a specific operation for which it is responsible (e.g., predetermined or configured to store). As described above, individual values of a weight fragment may belong to different partial weight vectors, and multiplication results (e.g., a result vector of $T \times 1$) between the individual values of the weight fragment and a single input scalar value may be accumulated in the same VRF. For example, a multiplication result between an input value (e.g., an ith input value in a partial input vector) and a weight value (e.g., a tth weight value among T weight values loaded according to a single operation command) of a weight fragment may be accumulated by being added to a tth value in a vector stored in a specific VRF 237. In this case, "t" may be an integer greater than or equal to 1 and less than or equal to T. A plurality of multiplication results (e.g., T multiplication results) between a plurality of weight values (e.g., a first weight value to a Tth weight value) and an input value (e.g., the ith input value) loaded according to a single operation command indicating a specific operation may be accumulated in the same VRF 237.

Further, when a plurality of operation commands (e.g., k operation commands) indicates the same VRF 237 among VRFs, results (e.g., multiplication result vectors) of specific operations corresponding to the operation commands may be accumulated in the VRF 237. For example, a summed vector of k multiplication result vectors corresponding to k operation commands may be stored in the VRF 237. For example, each of weight fragments loaded by the k operation commands may include T weight values, and a set of the loaded weight fragments may be mathematically interpreted as a partial weight matrix of $k \times T$. In this case, of this $k \times T$ partial weight matrix, a tth column vector (e.g., a partial weight vector of $k \times 1$) may belong to the same weight vector (e.g., the tth column vector) in the entire weight matrix (or a full weight matrix). Thus, as a matrix multiplication result between a $1 \times k$ partial input vector and the $k \times T$ partial weight matrix loaded by the k operation commands, a vector of $1 \times T$ (e.g., a summed vector of the k multiplication result vectors described above) may be stored in the VRF 237.

The plurality of ALUs 250 may perform arithmetic and logical operations used by a specific operation, under the control of the control circuit 210. The plurality of ALUs 250 may perform, in parallel, the first operation (e.g., the operation between the input scale factor and the weight scale factor) and the second operation (e.g., the operation between the input element and the weight element). For example, the plurality of ALUs 250 may be digital circuits that determine arithmetic operations including addition and subtraction and logical operations including exclusive disjunction (or exclusive or (XOR)), logical conjunction (or logical AND), and logical disjunction (or logical OR). However, examples are not limited thereto, and the plurality of ALUs 250 may also include a combination of digital circuits that determine MAC operations and/or modulo operations.

The plurality of ALUs 250 may include a first ALU 251, a second ALU 252, and an accumulator 257. The first ALU 251 may perform an operation using scale factors in the scale register files. For example, the first ALU 251 may perform an operation (e.g., the first operation) using the input scale factor in the first scale register file 231 and the weight scale factor in the second scale register file 232. The second ALU 252 may perform an operation using data (or values) stored in the SRF 235 and the memory bank 122. For example, the second ALU 252 may perform an operation (e.g., the second operation) using the input element in the SRF 235 and the weight element in the memory bank 122. As described below, in response to an operation command received from a host, the control circuit 210 may provide the first ALU 251 with a signal (e.g., the first operation signal) indicating the first operation and may provide the second ALU 252 with a signal (e.g., the second operation signal) indicating the second operation.

The accumulator 257 may generate an operation result based on the first operation and the second operation. For example, the accumulator 257 may generate the operation result by merging a first partial result from the first operation (e.g., an exponent determination) and a second partial result from the second operation (e.g., a mantissa determination). The accumulator 257 may add the generated operation result to a pre-stored value in the ARF. The accumulator 257 may include a combination of two or more ALUs (e.g., a multiplier and an adder).

In one or more embodiments, of a GEMV operation, a partial dot product operation (e.g., an operation corresponding to a partial vector of a column vector of a weight matrix) corresponding to the memory bank 122 may be allocated to the PIM block 121 of the memory device (e.g., 200a and 200b). This is because the PIM block 121 is accessible to the nearby memory bank 122 in the memory device (e.g., 200a and 200b). However, the size of data, or a data size (e.g., read size), that may be loaded by a single operation command may be limited. The data size loadable via a single operation command may be less than the size of the memory bank 122 and the size of a memory row. Due to this data size limitation, the partial dot product operation may be divided into a plurality of operation commands, and the host may provide the plurality of operation commands to the control circuit 210 of the PIM block 121 to instruct performing a plurality of specific operations.

For example, the host may transfer, to the memory device (e.g., 200a and 200b), operation commands respectively corresponding to weight fragments for a portion of the GEMV operation. The PIM block 121 may receive, from the host, operation commands corresponding to a plurality of weight fragments corresponding to an allocated portion of a target operation. The PIM block 121 may perform specific operations corresponding to the received operation commands. As described above, the memory device (e.g., 200a and 200b) may load different input fragments (e.g., input scalar values) corresponding to the operation commands from a plurality of SRFs 235. The PIM block 121 may also acquire weight fragments by accessing portions of the memory bank 122 corresponding to the operation commands. The memory device (e.g., 200a and 200b) may individually perform operations between the weight fragments and the input fragments using ALUs. For example, the memory device (e.g., 200a and 200b) may perform a multiplication operation between a corresponding weight fragment and a corresponding input fragment for each operation command. The memory device (e.g., 200a and 200b) may accumulate (e.g., sum up) a result of the multiplication operation in a corresponding VRF 237.

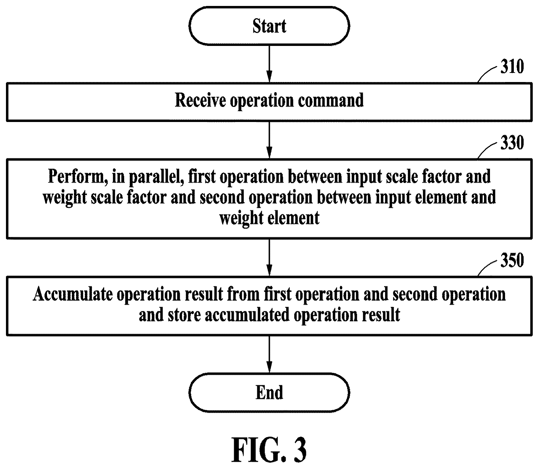

FIG. 3 illustrates an example of an operating method of a memory device according to one or more example embodiments. Steps 310 to 350 to be described hereinafter may be performed sequentially in the order and manner as shown and described below with reference to FIG. 3, but the order of one or more of the steps may be changed, one or more of the steps may be omitted, and two or more of the steps may be performed in parallel or simultaneously without departing from the scope of the claims.

In one or more embodiments, a memory device (e.g., a device including a DRAM) may store scale factors and an input vector before an operation command described below. For example, the memory device may store, in an SRF, input elements of the input vector received from a host. The memory device may store, in a first scale register file, an input scale factor received from the host. Of note, the input vector may be managed and/or archived by the host. The memory device may store, in a second scale register file, a weight scale factor of a weight vector received from a memory bank. The weight vector (or weight matrix) may be managed and/or archived by the memory bank. As further described below with reference to FIG. 4, the input vector may be represented by a plurality of input elements and the input scale factor according to a specific data format (e.g., microscaling (MX) data format), and the weight vector may be represented by a plurality of weight elements and the weight scale factor.

In one or more embodiments, the host may transmit an operation command to the memory device. As described above, the operation command may be a command indicating a specific operation of a target operation.

At step 310, the memory device may receive the operation command from the host. For example, the memory device may store the received operation command in an instruction register file (IRF). The memory device may process operation commands stored in the IRF in sequence or in parallel.

At step 330, the memory device may perform, in parallel, a first operation between the input scale factor and the weight scale factor and a second operation between the input element and the weight element. For example, in response to the received operation command, the memory device may perform, in parallel, the first operation between the input scale factor of the input value and the weight scale factor of the weight value and the second operation between the input element of the input value and the weight element of the weight value, by a plurality of ALUs. A control circuit of the memory device may generate, from the operation command, operation signals indicating a plurality of operations (e.g., addition, multiplication, and data conversion) for a specific operation. The control circuit may provide the generated operation signals to corresponding ALUs. For example, in response to the operation command, the control circuit may provide a first operation signal indicating the first operation to a first ALU of the plurality of ALUs, and a second operation signal indicating the second operation to a second ALU of the plurality of ALUs. As described below, the first ALU may perform, as the first operation, an addition of an exponent component of the input value and an exponent component of the weight value. The second ALU may perform, as the second operation, a multiplication of a mantissa component of the input value and a mantissa component of the weight value.

At step 350, the memory device may accumulate an operation result from the first operation and the second operation and store the accumulated operation result. The memory device may store, in an ARF, a result of accumulating operation results. For example, the memory device may add a new operation result to a value pre-stored in the ARF (e.g., a VRF). The memory device may update the VRF with a sum of the pre-stored value and the new operation result.

In one or more embodiments, in response to one operation command received from the host, the memory device may perform a specific operation (e.g., a MAC operation) using four operands. Of the four operands, an operation using two scale factors and an operation using two elements (e.g., an input element value and a weight element fragment) may be performed in parallel. This is because there is no operation dependency between the operation using the two scale factors and the operation using the two elements. Thus, the host of one or more embodiments may perform the operation using the two scale factors and the operation using the two elements in parallel (or simultaneously) without a fence. In addition, because a relatively less time is used for the operation using the two scale factors and the operation using the two elements, the memory device of one or more embodiments may perform data format conversion and summation (or accumulation) of operation results immediately after a specific cycle (e.g., a predetermined short waiting time) without intervention (e.g., additional command) from the host. Thus, the device and method of one or more embodiments may reduce and/or minimize fence overhead in MX data format-based operations. In this specification, of the MX data format, an MXINT8 data format is primarily described as an example. However, examples are not limited thereto, and the memory device may also support an MXFP8 data format, an MXFP6 data format, and an MXFP4 data format, depending on a simple hardware modification.

Further, there is no operation dependency among a plurality of operation commands, and thus the host may instruct the memory device in a plurality of operation commands, independently of the ordering (or order) according to a mathematical form of vectors, matrices, and tensors that are subject to a target operation. The host may also randomly provide a plurality of operation commands to the memory device without a fence.

FIG. 4 illustrates an example of a data format sharing a scale factor according to one or more example embodiments.

In one or more embodiments, a computing system may support a data format (e.g., an MX data format) based on a shared scale factor. The computing system of one or more embodiments may have reduced (or minimized) fence overhead in a dot product operation between two vectors (or a vector and a matrix, or matrices or tensors), in the data format based on the shared scale factor.

A large language model (LLM) may use the greatest time at a generation stage that generates a result in response to an input. The most time-consuming part of the generation stage may be moving data from a DRAM for operations (or computation). The computing system may include a PIM block to maximize the utilization of a memory bandwidth of the DRAM. A higher accuracy of the LLM may increase the model size. The LLM that may have model sizes in the billions to hundreds of billions or more may provide a great inference capability. The increased model size, however, may cause typical devices to experience a lack of memory capacity in the process of implementing and/or executing the LLM. To solve this issue, e.g., the lack of memory (e.g., DRAM) capacity in the computing system, the device and method of one or more embodiments may implement a shared scale factor-based data format.

The shared scale factor-based data format may be a data format in which multiple elements (e.g., k elements) share a single scale factor. An example of the shared scale factor-based data format may be an MX data format of the open compute project (OCP). Data indicating a specific numerical value may include a scale factor and an element (e.g., a private element). For example, in the data indicating the specific numerical value, the scale factor may indicate an exponent of the specific numerical value, and the private element may indicate a mantissa of the specific numerical value. A plurality of numerical values (e.g., k numerical values) respectively indicated by a plurality of data (e.g., k pieces of data) may be represented by one scale factor (e.g., one exponent) and a plurality of elements (e.g., k mantissas). In this case, "k" denotes a scale block size, which may define the number of elements that share the same scale factor, and may be an integer greater than or equal to 2. A group of one scale factor and the k elements for a representation of the k numerical values may also be referred to as a scale block (or a scaling block).

For example, all the elements may have the same data type (e.g., INT8) and may therefore have the same bit-width. The scale factor may be shared across the k elements, as described above. The data type of the elements and the data type of the scale factor may be selected independently. In a case where the number of bits used to encode a scale factor X is "w" and the number of bits used to represent each element $P_i$ is "d," the scale block representing the k numerical values may be encoded with $(w+kd)$ bits. Thus, the device and method of one or more embodiments may reduce the memory capacity used to represent the k numerical values, as one exponent and k mantissas are stored, compared to a typical device and method which uses a greater memory capacity to store k exponents and k mantissas.

As the size of a machine learning model (e.g., the number of connection weights based on the number of nodes and the number of layers) increases, the memory capacity occupied by input values and weight values may increase. The device and method of one or more embodiments may implement a large model (e.g., LLM) with more efficient memory capacity through hardware and/or operations that support a data format (e.g., the MX data format) sharing the scale factor described above.

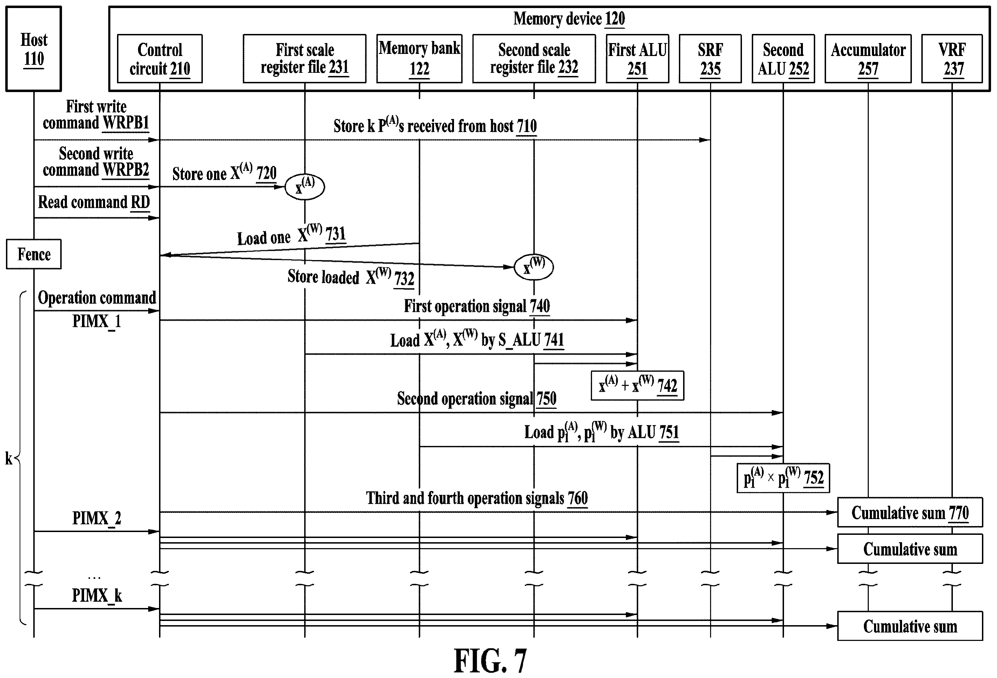

In one or more embodiments, in response to receiving a plurality of operation commands including the operation command from the host, the control circuit may perform a dot product operation between an input vector 410 including a plurality of input values and a weight matrix 430 including a plurality of weight values. The dot product operation may be decomposed into a plurality of specific operations. The specific operations may include a MAC operation between an input value 411 and a weight fragment 432, as described above. The present disclosure primarily describes an example where the specific operations include a multiplication (e.g., a first operation, a second operation, and a third operation of FIG. 7) between the input value 411 (e.g., a value represented by an input scale factor and an input element) of the input vector 410 and a weight value (e.g., a value represented by a weight scale factor and a weight element) of a weight vector and an addition (or summation) (e.g., a fourth operation of FIG. 7) of a multiplication result acquired by the multiplication to another multiplication result acquired by another multiplication.

Referring to FIG. 4, a matrix multiplication between the input vector 410 and the weight matrix 430 is shown. A partial input vector A including k input values in the input vector 410 and a partial weight vector W including k weight values in a column vector 431 of the weight matrix 430 may be represented in the data format that shares the scale factor. The input value 411 may be represented by an input scale factor and an input element. For example, the input scale factor may include an exponent component of the input value 411, and the input element may include a mantissa of the input value 411. The input element may also include a sign bit of the input value 411. The weight value may be represented by a weight scale factor and a weight element. The weight scale factor may include an exponent component of the weight value, and the weight element may include a mantissa component of the weight value. The weight element may also include a sign bit of the weight value.

The partial input vector A corresponding to a scale block $P^{(A)}$ may be expressed by Equation 1 below, for example. In Equation 1, $X^{(A)}$ denotes an input scale factor and $P_i^{(A)}$ denotes an ith input element. Here, i may be an integer of k or less.

Equation 1:

$$A: \left\{ X^{(A)}, \left[ P_i^{(A)} \right]_{i=1}^{k} \right\}$$

The partial weight vector W corresponding to a scale block $P^{(W)}$ may be expressed by Equation 2 below, for example. In Equation 2, $X^{(W)}$ denotes a weight scale factor and $P_i^{(W)}$ denotes an ith weight element. Here, i may be an integer of k or less.

Equation 2:

$$W: \left\{ X^{(W)}, \left[ P_i^{(W)} \right]_{i=1}^{k} \right\}$$

In Equation 1 and Equation 2 above, each scale factor may be represented by a w-bit binary number, and each element may be represented by a d-bit binary number. For example, the numerical value $X^{(A)}$ of the input scale factor may be represented by a binary number $x^{(A)}$, and the numerical value $P_i^{(A)}$ of the ith input element may be represented by a binary number $p_i^{(A)}$. Similarly, the numerical value $X^{(W)}$ of the weight scale factor may be represented by a binary number $x^{(W)}$, and the numerical value $P_i^{(W)}$ of the ith weight element may be represented by a binary number $p_i^{(W)}$. For example, in an MXINT8 data format, the input scale factor and the weight scale factor may include binary numbers representing the exponent components of the input value 411 and the weight value, respectively. In a case where an exponent component is $2^{128}$, a scale factor may include an 8-bit binary number "1000 0000$_2$" representing the exponent component. In a case where a sign is negative (-) and a mantissa component is 1.25, an element (e.g., private element) may include "1 1.010000$_2$." In the MXINT8 data format, a private element may include one sign bit as a first bit, one integer bit as a second bit, and fractional bits as the remaining six bits. However, it is provided only as an example, and components included in a scale factor and an element may vary depending on other formats of the MX data format (e.g., MXFP8, MXFP6, and MXFP4) and, furthermore, the definition of the formats.

Of note, the embodiments of the present disclosure including the example of FIG. 4 describe a dot product operation between one partial weight vector W (e.g., a tth column vector of $k \times 1$) and a partial input vector A (e.g., a partial input vector A of $1 \times k$). This may also be interpreted as an example where T = 1, in the weight fragment 432 including T weight values loaded by each operation command. However, this example is provided for simplicity, and the operations and structures described herein should be interpreted as being expanded not only to the example where T=1 but also to examples where T is greater than 1 (e.g., T=16). As described above with reference to FIGS. 1 through 3, one operation command may indicate a specific operation (e.g., a MAC operation) on the weight fragment 432 including the weight values by which the same input value 411 is multiplied, in a plurality of weight vectors. Although, among T weight values of the weight fragment 432 loaded by one operation command, one weight value (e.g., a tth weight value) is primarily described with reference to FIGS. 4 through 10, the same operation may be applied to the remaining weight values.

FIG. 5 illustrates an example of an operation on data represented in a data format according to one or more example embodiments.

An operation 501 that is based on a data format (e.g., an MX data format) according to a comparative embodiment may be expressed by Equation 3 below, for example.

Equation 3:

$$C = \mathrm{Dot}(A, W) = (X^{(A)} X^{(W)} \sum_{i=1}^{k} (P_i^{(A)} \times P_i^{(W)}))$$

In the operation 501 of Equation 3, according to the comparative embodiment, a multiplication between elements (e.g., $P_i^{(A)}$ and $P_i^{(W)}$) may be performed k times first. In response to k multiplication results being added (or summed up), a summed result may be multiplied by scale factors (e.g., $X^{(A)}$ and $X^{(B)}$). In this case, operations may be performed alternately according to the following ordering: a multiplication (or product) of grouped elements (e.g., elements belonging to the same scale block) → scale operation (or scaling operation). Here, when data stored in a register file of a PIM changes, a host may use a fence to maintain the ordering. In the comparison embodiment, register files may change between a product of elements and a product of the scale operation. However, such frequent changes in the register files may increase fence overhead. When there is a dependency on the ordering of operations, such as in the operation 501 according to Equation 3 above, and a DRAM request ordering changes in the PIM, the host should use a fence to hold an additional command (or instruction) for a memory device. As the fence overhead increases, an effect from the performance of the PIM may be reduced, and operation efficiency (or computational efficiency) may decrease.

On the other hand, in the memory device of one or more embodiments, a control circuit of **a PIM** block may instruct a first ALU in an addition operation, as a first operation, to add an exponent component of an input value and an exponent component of a weight value. The control circuit may also instruct a second ALU in a multiplication operation, as a second operation, to multiply a mantissa component of the input value and a mantissa component of the weight value. The control circuit may instruct different ALUs to perform, in parallel (or simultaneously), the first operation and the second operation described above for a single operation command. For example, a data format-based operation (e.g., operation 501), according to one or more embodiments, may be expressed by Equation 4 below, for example.

Equation 4:

$$C = \mathrm{Dot}(A, W) = \sum_{i=1}^{k} (X^{(A)} \times X^{(W)} \times P_i^{(A)} \times P_i^{(W)})$$

In an operation 510 according to Equation 4 above, for each of k times of operations (or k operations), the operations with four operands, e.g., a scale operation using $X^{(A)}$ and $X^{(W)}$ and a multiplication operation using $P_i^{(A)}$ and $P_i^{(W)}$, may be processed in parallel (or simultaneously). For example, as shown in FIG. 5, the scale operation between $X^{(A)}$ and $X^{(W)}$ may be an exponent addition 530 (e.g., $X^{(A)} + x^{(W)}$) between binary numbers $X^{(A)}$ and $x^{(W)}$ representing exponent values. This is because an exponent value of a result (e.g., $2^{128=100+28}$) of multiplying two exponent components (e.g., $2^{100}$ and $2^{28}$) corresponds to a result of adding the two exponent values. The operation between the elements $P_i^{(A)}$ and $P_i^{(W)}$ may be an element multiplication 550 (e.g., $P_i^{(A)} \times p_i^{(W)}$) of binary numbers $p_i^{(A)}$ and $p_i^{(W)}$.

The memory device may start a type conversion 570 in response to an ith exponent addition 530 and element multiplication 550 being completed. Because the exponent addition 530 and the element multiplication 550 use a predictably small number of cycles, the memory device may perform the type conversion 570 when a predetermined time (e.g., a first specific cycle) has elapsed from a start point of the exponent addition 530 and the element multiplication 550. By the type conversion 570, a first partial result of the first operation (e.g., the exponent addition 530) and a second partial result of the second operation (e.g., the element multiplication 550) may be converted into a specific data format (e.g., FP32). The data format may also be referred to herein as a data type. An operation result 571 from the exponent addition 530, the element multiplication 550, and the type conversion 570 may be represented by a sign bit S (e.g., one bit), an exponent bit E (e.g., eight bits), and a mantissa bit M (e.g., 23 bits).

Once the type conversion 570 is completed, the memory device may perform an addition operation to generate a MAC result 590. Because the type conversion 570 also uses a predictably small number of cycles, the memory device may perform an addition operation between the operation result 571 and another operation result 579 to generate the MAC result 590 when a predetermined time (e.g., a second specific cycle) has elapsed from a start point of the type conversion 570.

As described above, an operation dependency may be mitigated between the exponent addition 530, the element multiplication 550, the type conversion 570, and the addition operation of operation results. Therefore, according to one or more embodiments, the memory device of one or more embodiments may reduce and/or minimize fences that are caused by the host, unlike the comparative embodiment.

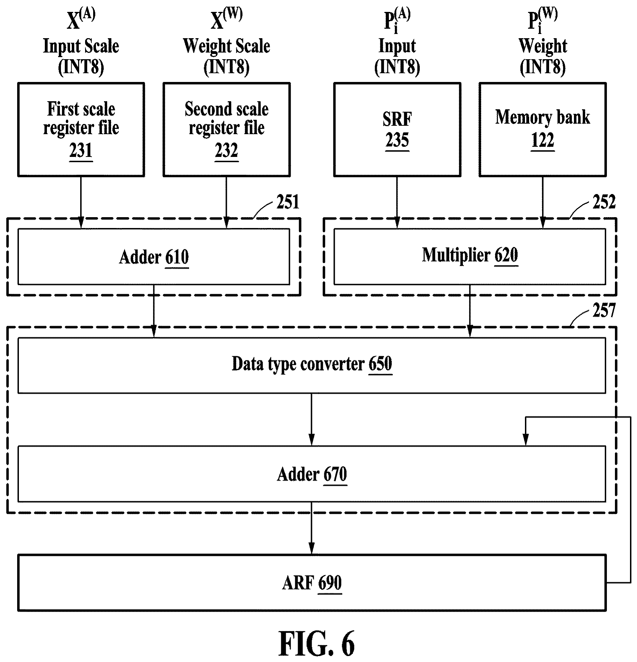

FIG. 6 illustrates an example configuration of a PIM block supporting an operation on data represented in a data format according to one or more example embodiments.

In one or more embodiments, a memory device may include register files for scales, ALUs for operations between scale factors, and an accumulator 257.

The register files for the scales may include, for example, a first scale register file 231 (e.g., an input scale register file (IS_RF) for input scale factors) and a second scale register file 232 (e.g., a weight scale register file (IS_RF) for weight scale factors).

A first ALU 251, which is a device for a first operation between scale factors, may include an adder 610 (e.g., INT8ADD) for an integer addition between scale factors (e.g., exponent values), for example. A second ALU 252, which is a device for a second operation between elements, may include a multiplier 620 (e.g., INT8MUL) for an integer multiplication between elements (e.g., mantissas that are private elements), for example.

In one or more embodiments, a control circuit of a PIM block may receive an operation command (e.g., a PIMX command) received from a host. The operation command may be, for example, a DRAM RD command in all-bank PIM mode. In response to receiving the PIMX command (e.g., DRAM RD command), the control circuit of the PIM block may instruct corresponding ALUs to perform operations with operands stored in the respective register files and/or a memory bank 122. For example, in response to the received operation command, the control circuit may provide a first operation signal to the first ALU 251 and a second operation signal to the second ALU 252. The adder 610 that has received the first operation signal may load an input scale factor (e.g., a scalar value in INT8 format) stored in the first scale register file 231 and a weight scale factor (e.g., a scalar value in INT8 format) stored in the second scale register file 232, and perform an addition operation of the two loaded scale factors. The multiplier 620 that has received the second operation signal may perform a multiplication operation between an input element (e.g., a scalar value in INT8 format) stored in an SRF 235 and a weight fragment (e.g., weight values in INT8 format) stored in the memory bank 122.

The accumulator 257 may generate an operation result by merging a first partial result of the first operation and a second partial result of the second operation into a specific data format. The accumulator 257 may add the generated operation result to a pre-stored value in an ARF 690. For example, the accumulator 257 may include a data type converter 650 and an adder 670 (e.g., FP32ADD).

The data type converter 650 may generate the operation result by merging the first partial result of the first operation (e.g., exponent addition) and the second partial result of the second operation (e.g., element multiplication) into the specific data format, as described above with reference to FIG. 5. For example, in a case where the data type converter 650 is FP32 Convert, it may generate an operation result that conforms to FP32 by arranging the first partial result and the second partial result. This is because the FP32 format has a 1-bit sign value, an 8-bit exponent value, and a 23-bit mantissa value, while the first partial result of the adder 610 (e.g., INT8ADD) may be 9 bits and the second partial result of the multiplier 620 (e.g., INT8MUL) may be 16 bits, due to increased carry or the like.

The adder 670 of the accumulator 257 may add the operation result converted into the specific data type to another operation result (e.g., a pre-stored value in the ARF 690) and store a result of the addition to the ARF 690. The adder 670 may perform an addition of the operation result generated by the data type converter 650 to the pre-stored value in the ARF 690. The memory device may therefore output, as a resulting value, data in FP32 format that conforms to an MX data format specification. The ARF 690 may be implemented by being integrated into a VRF as described above but may also be implemented as a register file separate from the VRF.

Of note, although an example of an operation that is based on the MXINT8 data format is primarily described with reference to FIG. 6, examples are not limited thereto, and the memory device of one or more embodiments may also be applied to other data formats. For example, in the MXFP8 data format, elements may conform to the FP format including sign, exponent, and mantissa, and the second ALU 252 may be implemented as FP16ALU. The FP16ALU may include at least one of FP16ADD or FP16MUL. The first ALU 251 may also be implemented as the FP16ALU, and the memory device may thus process data in a wider variety of formats, enabling the mitigation of the limitation of processible data formats.

FIG. 7 illustrates an example of a MAC operation performed in a computing system according to one or more example embodiments.

In one or more embodiments, a host 110 may prepare, before k operation commands (or m×k operation commands), values to be used in the operation commands. For example, the host 110 may provide a memory device 120 (e.g., a control circuit 210) with a first write command (WRPB1) indicating writing of an input element, a second write command (WRPB2) indicating writing of an input scale factor, and a read command (RD) indicating storing a weight scale factor.

At step 710, in response to a command (e.g., the first write command WRPB1) preceding an operation command, the control circuit 210 may receive an input element (e.g., $k P^{(A)}S$) from the host 110 and store the received input element in an SRF 235.

At step 720, in response to a command (e.g., the second write command WRPB2) preceding the operation command, the control circuit 210 may receive an input scale factor from the host 110 and store the received input scale factor (e.g., $X^{(A)}$) in a first scale register file 231.

At step 731, in response to a command (e.g., the read command RD) preceding the operation command, the control circuit 210 may load a weight scale factor from a memory bank 122. At step 732, the control circuit 210 may store the loaded weight scale factor in a second scale register file 232.

In response to the host 110 transmitting the write commands WRPB1 and WRPB2 and the read command RD to the memory device 120, the host 110 may wait until storing the corresponding values in the respective register files is guaranteed. Thus, the memory device 120 may receive the input scale factor and the input element from the host 110 in response to the commands preceding the operation command, and may load the weight scale factor from the memory bank 122 in response to the command preceding the operation command. For example, the host 110 may wait through a fence. In response to the fence, the host 110 may provide the operation command (e.g., a first operation command (e.g., PIMX_1)) to the control circuit 210 of the memory device 120.

At step 740, in response to the operation command, the control circuit 210 may provide a first operation signal to a first ALU 251. The control circuit 210 may instruct the first ALU 251 to perform a first operation (e.g., an addition operation) between the scale factors (e.g., the input scale factor and the weight scale factor) through the first operation signal. At step 741, the first ALU 251 that has received the first operation signal may load the input scale factor $X^{(A)}$ stored in the first scale register file 231 and the weight scale factor $W^{(A)}$ stored in the second scale register file 232. At step 742, the first ALU 251 may perform the addition operation between the scale factors (e.g., $x^{(A)} + x^{(W)}$).

At step 750, in response to the operation command, the control circuit 210 may provide a second operation signal to a second ALU 252. The control circuit 210 may instruct the second ALU 252 to perform a second operation (e.g., a multiplication operation) between private elements (e.g., an input value and a weight fragment) through the second operation signal. At step 751, the second ALU 252 that has received the second operation signal may load an input element $p_1^{(A)}$ stored in the SRF 235 and a weight element $p_1^{(W)}$ stored in the memory bank 122. At step 752, the second ALU 252 may perform the multiplication operation between the elements (e.g., $p_1^{(A)} \times p_1^{(W)}$).

In one or more embodiments, the control circuit 210 may instruct parallel and/or simultaneous processing of the first operation between the scale factors at step 740 and the second operation between the private elements at step 750. Therefore, steps 740, 741, and 742 for the first operation and steps 750, 751, and 752 for the second operation may be performed in parallel.

At step 760, the control circuit 210 may provide a third operation signal and a fourth operation signal to an accumulator 257. The control circuit 210 may instruct an accumulation operation to accumulate results of the first operation and the second operation. For example, the control circuit 210 may instruct a circuit of the accumulator 257 (e.g., FP32 Convert and FP32 ADD) to accumulate the results of the first operation and the second operation. At step 770, the accumulator 257 may perform a cumulative summation based on the third operation signal and the fourth operation signal.

In one or more embodiments, the control circuit 210 may provide the accumulator 257 with the third operation signal indicating a data format conversion at a timing when a first specific cycle has elapsed from the first operation signal for the first operation and the second operation signal for the second operation. For example, the third operation signal may be a signal indicating a conversion from a first partial result of the first operation and a second partial result of the second operation into an operation result represented in the specific data format. As described above, because the first operation and the second operation consume a predictably short time, the first specific cycle may be determined based on a time determined and/or predicted as being used for the first operation and/or the second operation. For example, the memory device 120 may acquire an operation result between the input value and the weight value from the first partial result of the first operation and the second partial result of the second operation. For example, the control circuit 210 may instruct a format converter of the circuit of the accumulator 257 to convert the first partial result and the second partial result into data in a predetermined format (e.g., FP32 data indicating the operation result).

In one or more embodiments, the control circuit 210 may provide the accumulator 257 with the fourth operation signal indicating an addition of the operation result and a pre-stored value (e.g., a value in an ARF) of the accumulator 257 at a timing when a second specific cycle has elapsed from the third operation signal. As described above, because a third operation(e.g., the data format conversion) consumes a predictably short time, the second specific cycle may be determined based on a time determined and/or predicted as being used for the third operation.

In one or more embodiments, the memory device 120 may store the converted data in the ARF (or a VRF 237). In a case where there is data (or value) already stored in the ARF, the memory device 120 may add the converted data from the results of the first operation and the second operation to the ARF. Therefore, results of a plurality of operations may be accumulated.

In one or more embodiments, the host 110 may additionally provide the memory device 120 with other operation commands (e.g., PIMX_2 and PIMX_k) after the operation command. In this case, a third specific cycle may be determined for the fourth operation signal in a similar way the first specific cycle is determined for the first operation signal and/or the second operation signal and the second specific cycle is determined for the third operation signal, as described above. The third specific cycle may be determined based on a time determined and/or predicted as being used for a fourth operation (e.g., the addition or summation operation). The host 110 may provide a subsequent operation command to the control circuit 210 of the memory device 120 when a predetermined time (e.g., a cycle determined based on the summation of the first specific cycle, the second specific cycle, and the third specific cycle) has elapsed from a time point at which the operation command was provided to the memory device 120. The host 110 may thus control a PIM block of the memory device 120 to perform a scale operation and a MAC operation by one operation command, and may provide a subsequent operation command to the memory device 120 without a fence.

FIG. 8 illustrates an example of a reduced fence in a computing device according to one or more example embodiments.

In one or more embodiments, a control circuit may receive, from a host, and process a first plurality of operation commands (e.g., k operation commands 870 corresponding to a first scale block) for data sharing a first scale factor and a second plurality of operation commands (e.g., k operation commands corresponding to a subsequent scale block) for data sharing a second scale factor, without a fence. For example, the operation commands (PIMX_1 to PIMX_k) described with reference to FIG. 7 may be the first plurality of operation commands.

For example, referring to FIG. 8, m partial input vectors may be formed by grouping k input values of an input vector. Each partial input vector may include k input values and may be represented by a scale block of k input elements sharing the same input scale factor. Similarly, m partial weight vectors may be formed by grouping k weight values of a column vector of a weight matrix. Each partial weight vector may include k weight values and may be represented by a scale block of k weight values sharing the same weight scale factor. In this example, "m" may be an integer greater than or equal to 1.

In one or more embodiments, a host 110 may provide a memory device with commands (e.g., a first write command (WRPB1), a second write command (WRPB2), and a read command (RD)) that instruct the memory device to prepare data for k × m operation commands (e.g., PIMX commands). In response to providing the prepared commands to a PIM block 121, the host 110 may wait through a fence (e.g., Fence_A 850). The Fence_A 850 may represent a fence arranged between preparing data for an operation and giving an operation command for the operation.

The host 110 may provide the PIM block 121 with k operation commands 870 corresponding to a first scale block among m scale blocks. The operation commands 870 may correspond to a dot product between a partial input vector 810 and a partial weight vector 830. The PIM block 121 of the memory device may generate a first MAC operation result 890 as described above with reference to FIG. 7. Subsequently, the host 110 may provide the **PIM** block 121 with k operation commands corresponding to a subsequent scale block (e.g., a second scale block) without a fence. The host 110 may continue to provide the PIM block 121 with operation commands corresponding to the m scale blocks without a fence. As described above, due to a mitigated operation dependency between operation commands, the host 110 may also provide the k × m operation commands to the **PIM** block 121 of the memory device in any ordering (e.g., randomly or in an ordering that may be more computationally efficient), independent of the ordering according to Equation 4.

In a computing system of one or more embodiments, the Fence_A 850 may be used only when updating a scale factor and an input element in respective register files. For example, when completing processing operation commands for the m scale blocks, the computing system may update the register files for a subsequent operation and wait with the Fence_A 850. However, the conditions under which the Fence_A 850 occurs are not limited to the preceding example. For example, the extent to which a weight matrix is processible without a fence may be determined based on at least one of the size and number of register files of the PIM block 121 (e.g., the number of first scale register files, the number of second scale register files, the number of SRFs, and the number of VRFs), the number k of elements sharing the same scale factor in a data format, or the size of data that is loadable as one operation command.

As described above, because the Fence_A 850 is only used after the data has been prepared, the device and method of one or more embodiments may significantly reduce a runtime of a target operation (e.g., a GEMV operation). Using the reduction in fence overhead described above, the device and method of one or more embodiments may improve the performance twofold (2x) to threefold (3x), compared to the comparative embodiment.

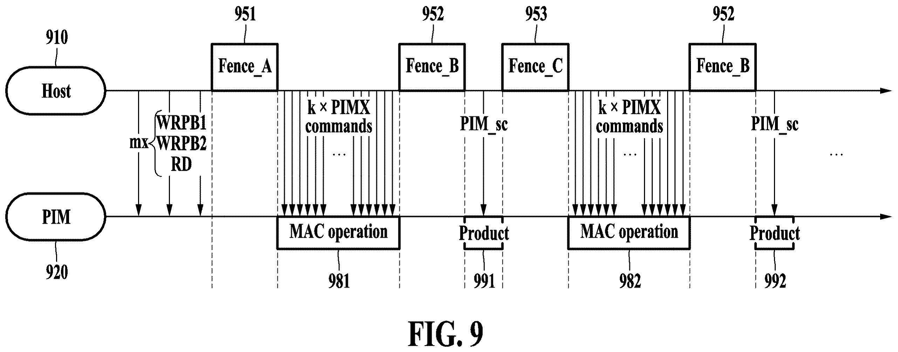

FIG. 9 illustrates an example of a fence used according to a comparative example embodiment.

In a comparative embodiment, (i) a host 910 may instruct a PIM block 920 to store a partial input vector (e.g., input elements) in an SRF, and (ii) the host 910 may instruct the PIM block 920 to store an input scale factor in the SRF. After (i) and (ii), the host 910 may wait through a fence (e.g., Fence_A 951). As described above, the Fence_A 951 may guarantee that the input elements, the input scale factor, and a weight scale factor are fully stored in SRFs before performing an operation command (e.g., a PIMX command).

Subsequently, (iii) when MX data format-based data for an operation is all ready, the host 910 may request the PIM block 920 of a memory device (e.g., a DRAM device) to perform a MAC operation 981 (e.g., an operation command). The host 910 may instruct the operation command k times according to the grouping number k of scale blocks (e.g., k=32).

In this case, after the MAC operation 981 is performed 32 times at (iii), a fence (e.g., Fence_B 952) may be requested. In the comparative embodiment, the Fence_B 952 may be used to ensure the ordering of a MAC operation and a scale operation (e.g., a multiplication (or product 991)) that follows the ordering according to Equation 3. If the Fence_B 952 is not present, an error in which the product 991 for the scale operation is performed before the MAC operation 981 is completed may occur.

After the Fence_B 952, (iv) the host 910 may instruct the PIM block 920 to perform the scale operation using the input scale factor and the weight scale factor.

In this case, after the scale operation at (iv), an additional fence (e.g., Fence_C 953) may be used before performing a subsequent MAC operation 982. This is because, similar to the Fence_B 952 described above, the ordering of the scale operation and the subsequent MAC operation 982 needs to be guaranteed due to the operation dependency according to Equation 3.

Subsequently, steps (iii) and (iv) may be repeated until all input elements and input scale factors stored in the SRFs have been utilized. Accordingly, the Fence_B 952 between the subsequent MAC operation 982 and a product 992 based on a subsequent scale operation and the additional Fence_C 953 after the product 992 may also be repeated. Thus, in the comparative embodiment, such an excessive use of fences may reduce operation efficiency.

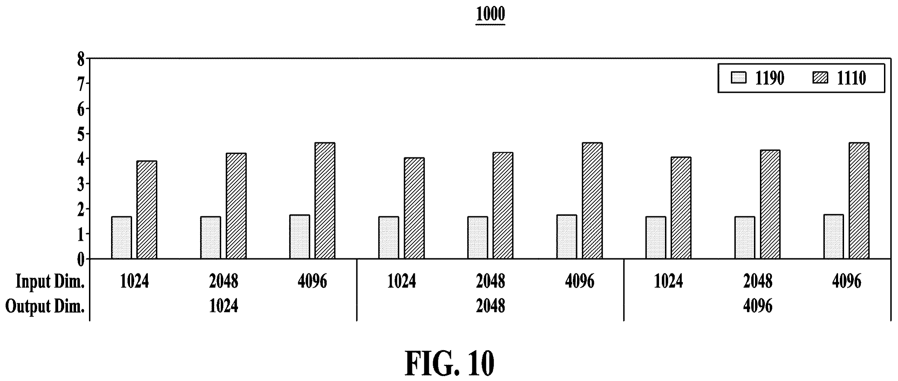

FIG. 10 illustrates an improved performance of a memory device according to one or more example embodiments over a comparative example embodiment.

FIG. 10 illustrates a comparison 1000 between performance 1190 according to the comparative embodiment and performance 1110 of a memory device according to one or more embodiments. A horizontal axis represents a matrix dimension of data used as a GEMV dimension, and a vertical axis represents a relative performance improvement ratio, which may be a ratio of the processing speed of the comparative embodiment to the processing speed of the baseline embodiment, and a ratio of the processing speed of one or more embodiments of the present disclosure to the processing speed of the baseline embodiment. For example, a value on the vertical axis may be 1 when the processing speed of one or more embodiments is the same as the processing speed of the baseline embodiment or may be 2 when the processing speed of one or more embodiments is twice the processing speed of the baseline embodiment. The baseline embodiment may represent a typical computing system without a PIM. As shown in FIG. 10, while the performance 1190 of the comparative embodiment is less than twice that of the baseline embodiment, the performance 1110 of the memory device according to one or more embodiments may be improved about fourfold (4x) to fivefold (5x) that of the baseline embodiment across values 1024, 2048, and 4096, which are commonly used in an LLM, and may be improved twofold (2x) to threefold (3x) compared to that of the comparative embodiment.

The computing systems, hosts, memory devices, PIM blocks, memory banks, control circuits, register files, first scale register files, second scale register files, SRFs, VRFs, ALUs, first ALUs, second ALUs, accumulators, adders, multipliers, data type converters, ARFs, computing system 100, host 110, memory device 120, PIM block 121, memory bank 122, memory device 200a, control circuit 210, register files 230, first scale register file 231, second scale register file 232, SRF 235, VRF 237, ALUs 250, first ALU 251, second ALU 252, accumulator 257, memory device 200b, adder 610, multiplier 620, data type converter 650, adder 670, ARF 690, host 910, and PIM block 920 described herein, including descriptions with respect to respect to FIGS. 1-10, are implemented by or representative of hardware components. As described above, or in addition to the descriptions above, examples of hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices that is configured to respond to and execute instructions in a defined manner to achieve a desired result. In one example, a processor or computer includes, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. As described above, or in addition to the descriptions above, example hardware components may have any one or more of different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods illustrated in, and discussed with respect to, FIGS. 1-10 that perform the operations described in this application are performed by computing hardware, for example, by one or more processors or computers, implemented as described above implementing instructions (e.g., computer or processor/processing device readable instructions) or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations.

Instructions or software to control computing hardware, for example, one or more processors or computers, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions herein, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media, and thus, not a signal per se. As described above, or in addition to the descriptions above, examples of a non-transitory computer-readable storage medium include one or more of any of read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD- Rs, DVD+Rs, DVD-RWs, DVD+RWs, DVD-RAMs, BD-ROMs, BD-Rs, BD-R LTHs, BD-REs, blue-ray or optical disk storage, hard disk drive (HDD), solid state drive (SSD), flash memory, a card type memory such as multimedia card micro or a card (for example, secure digital (SD) or extreme digital (XD)), magnetic tapes, floppy disks, magneto-optical data storage devices, optical data storage devices, hard disks, solid-state disks , and/or any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples without departing from the scope of the claims. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

Therefore, in addition to the above and all drawing disclosures, the scope of the invention is disclosed by the enclosed claims.

**Claims**

1. A memory device, comprising:

   a processing-in-memory, PIM, block configured to perform an operation between a weight value, which is represented by a weight scale factor and a weight element, and an input value, which is represented by an input scale factor and an input element,
   wherein the PIM block comprises:

   a first scale register file storing the input scale factor;
   a second scale register file storing the weight scale factor;
   a scalar register file, SRF, storing the input element;
   a plurality of arithmetic logic units, ALUs, configured to, in response to an operation command received from a host, perform, in parallel, a first operation between the input scale factor and the weight scale factor and a second operation between the input element and the weight element; and
   an accumulator configured to accumulate and store an operation result from the first operation and the second operation.

2. The memory device of claim 1, further comprising a control circuit configured to, for the performing of the first operation and the second operation in parallel, in response to the operation command, provide, in parallel, a first operation signal instructing a first ALU among the plurality of ALUs according to the first operation and provide a second operation signal instructing a second ALU among the plurality of ALUs according to the second operation.

3. The memory device of claim 2, wherein, for the accumulating and storing of the operation result, the control circuit is configured to provide the accumulator with a third operation signal indicating a conversion into the operation result represented in a specific data format from a first partial result of the first operation and a second partial result of the second operation, at a timing after a first specific cycle has elapsed from the first operation signal and the second operation signal.

4. The memory device of claim 3, wherein, for the accumulating and storing of the operation result, the control circuit is configured to provide the accumulator with a fourth operation signal indicating an addition of the operation result to a pre-stored value of the accumulator, at a timing after a second specific cycle has elapsed from the third operation signal.

5. The memory device of one of claims 1 to 4, further comprising:

   an accumulation register file, ARF,
   wherein the accumulator comprises:

   a data type converter configured to generate the operation result by merging a first partial result of the first operation and a second partial result of the second operation into a specific data format; and
   an adder configured to add the generated operation result to a pre-stored value in the ARF.

6. The memory device of one of claims 1 to 5, wherein

   the input scale factor comprises an exponent component of the input value,
   the input element comprises a mantissa component of the input value,
   the weight scale factor comprises an exponent component of the weight value, and
   the weight element comprises a mantissa component of the weight value.

7. The memory device of claim 6, wherein the plurality of ALUs comprises:

a first ALU configured to perform, as the first operation, an addition of the exponent component of the input value and the exponent component of the weight value; and

a second ALU configured to perform, as the second operation, a multiplication of the mantissa component of the input value and the mantissa component of the weight value.

8. The memory device of one of claims 1 to 7, configured to, in response to receiving, from the host, a plurality of operation commands comprising the operation command, perform a dot product operation between an input vector comprising a plurality of input values and a weight matrix comprising a plurality of weight values.

9. The memory device of one of claims 1 to 8,
   further comprising a memory bank storing the weight scale factor and the weight element, wherein

   the input scale factor and the input element are received from the host, in response to a command preceding the operation command, and

   the weight scale factor is loaded from the memory bank, in response to a command preceding the operation command.

10. The memory device of one of claims 1 to 9, configured to receive, from the host, and process a first plurality of operation commands for data sharing a first scale factor and a second plurality of operation commands for data sharing a second scale factor, without a fence.

11. The memory device of one of claims 1 to 10, configured to:

    in response to a command preceding the operation command, receive the input scale factor from the host and store the received input scale factor in a first scale register file; and

    in response to a command preceding the operation command, receive the input element from the host and store the received input element in the scalar register file, SRF; and

    in response to a command preceding the operation command, load the weight scale factor from a memory bank and store the loaded weight scale factor in the second scale register file.

12. A method of operating a processing-in-memory, PIM, device comprising a plurality of arithmetic logic units, ALUs, configured to, for each of a plurality of input elements sharing a same input scale factor and each of a plurality of weight elements sharing a same weight scale factor, the method comprises performing:

    a first operation between the same input scale factor received from a first scale register file and the same weight scale factor received from a second scale register file; and

    a second operation between the respective input element received from a scalar register file, SRF, and the respective weight element.

13. The operating method of claim 12, wherein the first operation and the second operation are performed in parallel by the plurality of ALUs, and further comprising:

    in response to the operation command, providing a first ALU among the plurality of ALUs with a first operation signal indicating the first operation; and

    providing a second ALU among the plurality of ALUs with a second operation signal indicating the second operation, wherein the providing of the first operation signal and the providing of the second operation signal are performed in parallel by a control circuit.

14. The operating method of claim 13, further comprising storing an accumulated operation result by providing an accumulator with a third operation signal indicating a conversion into the operation result represented in a specific data format from a first partial result of the first operation and a second partial result of the second operation, at a timing after a first specific cycle has elapsed from the first operation signal and the second operation signal.

15. The operating method of claim 14, wherein the storing of the accumulated operation result comprises providing the accumulator with a fourth operation signal indicating an addition of the operation result and a pre-stored value of the accumulator, at a timing after a second specific cycle has elapsed from the third operation signal.

<u>100</u>

Host
<u>110</u>

Memory device <u>120</u>

Memory bank
<u>122</u>

PIM block
<u>121</u>

· · ·                                                    · · ·

# FIG. 1

**FIG. 2A**

FIG. 2B

```
                        ┌──────────────┐
                        │    Start     │
                        └──────┬───────┘
                               │
                               ▼              ╭ 310
         ┌─────────────────────────────────────────────┐
         │          Receive operation command          │
         └─────────────────────┬───────────────────────┘
                               │
                               ▼              ╭ 330
         ┌─────────────────────────────────────────────┐
         │ Perform, in parallel, first operation       │
         │ between input scale factor and              │
         │ weight scale factor and second operation    │
         │ between input element and weight element    │
         └─────────────────────┬───────────────────────┘
                               │
                               ▼              ╭ 350
         ┌─────────────────────────────────────────────┐
         │ Accumulate operation result from first      │
         │ operation and second operation              │
         │ and store accumulated operation result      │
         └─────────────────────┬───────────────────────┘
                               │
                               ▼
                        ┌──────────────┐
                        │     End      │
                        └──────────────┘
```

# FIG. 3

FIG. 4

EP 4 742 052 A1

$$C = \mathrm{Dot}(A,W) = (X^{(A)} X^{(W)} \sum_{i=1}^{k} (P_i^{(A)} \times P_i^{(W)})$$

501

$$C = \mathrm{Dot}(A,W) = \sum_{i=1}^{k} (X^{(A)} \times X^{(W)} \times P_i^{(A)} \times P_i^{(W)})$$

510

i=1

$X^{(A)} \times X^{(W)}$ → Exponent addition → $x^{(A)} + x^{(W)}$   530

$P_1^{(A)} \times P_1^{(W)}$ → Element multiplication → $p_i^{(A)} \times p_i^{(W)}$   550

→ Type conversion → | $S_1$ | $E_1$ | $M_1$ |   570   571

+

i=k

$X^{(A)} \times X^{(W)}$ → Exponent addition → $x^{(A)} + x^{(W)}$

$P_k^{(A)} \times P_k^{(W)}$ → Element multiplication → $p_k^{(A)} \times p_k^{(W)}$

→ Type conversion → | $S_k$ | $E_k$ | $M_k$ |   579

+

590 → MAC result

## FIG. 5

EP 4 742 052 A1

$X^{(A)}$
**Input Scale
(INT8)**

$X^{(W)}$
**Weight Scale
(INT8)**

$P_i^{(A)}$
**Input
(INT8)**

$P_i^{(W)}$
**Weight
(INT8)**

| First scale register file **231** | Second scale register file **232** | SRF **235** | Memory bank **122** |

251

252

| Adder **610** | | Multiplier **620** |

257

| Data type converter **650** |

| Adder **670** |

| ARF **690** |

**FIG. 6**

FIG. 7

FIG. 8

FIG. 9

FIG. 10

Europäisches
Patentamt

European
Patent Office

Office européen
des brevets

# EUROPEAN SEARCH REPORT

**Application Number**

EP 25 21 4981

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 118 626 049 A (TAIWAN SEMICONDUCTOR MFG CO LTD) 10 September 2024 (2024-09-10)<br>* figure 1 *<br>* paragraph [0001] - paragraph [0003] *<br>* paragraph [0019] - paragraph [0068] *<br>----- | 1-15 | INV.<br>G06F15/78 |
| X | US 2024/232285 A9 (D MATRIX CORP [US]) 11 July 2024 (2024-07-11)<br>* figure 3B *<br>* paragraph [0008] - paragraph [0009] *<br>* paragraph [0049] - paragraph [0058] *<br>* paragraph [0097] - paragraph [0143] *<br>----- | 1-15 | |
| X | US 2021/208882 A1 (SONG CHOUNG KI [KR]) 8 July 2021 (2021-07-08)<br>* paragraph [0195] - paragraph [0242] *<br>----- | 1-15 | |

**TECHNICAL FIELDS
SEARCHED (IPC)**

G06F

The present search report has been drawn up for all claims

| Place of search | Date of completion of the search | Examiner |
|---|---|---|
| The Hague | 10 March 2026 | De Poy, Iker |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

 

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 21 4981

This annex lists the patent family members relating to the patent documents cited in the above-mentioned European search report.
The members are as contained in the European Patent Office EDP file on
The European Patent Office is in no way liable for these particulars which are merely given for the purpose of information.

10-03-2026

| Patent document cited in search report | | Publication date | Patent family member(s) | | Publication date |
|---|---|---|---|---|---|
| CN 118626049 | A | 10-09-2024 | NONE | | |
| US 2024232285 | A9 | 11-07-2024 | CN | 221960554 U | 05-11-2024 |
| | | | DE | 202023106035 U1 | 19-03-2024 |
| | | | TW | 202429312 A | 16-07-2024 |
| | | | US | 2024134930 A1 | 25-04-2024 |
| US 2021208882 | A1 | 08-07-2021 | US | 2021208879 A1 | 08-07-2021 |
| | | | US | 2021208881 A1 | 08-07-2021 |
| | | | US | 2021208882 A1 | 08-07-2021 |
| | | | US | 2021208883 A1 | 08-07-2021 |
| | | | US | 2021208884 A1 | 08-07-2021 |

EPO FORM P0459

For more details about this annex : see Official Journal of the European Patent Office, No. 12/82